# EUROPÄISCHE PATENTSCHRIFT

(11) **EP 3 244 127 B1**
(45) Veröffentlichungstag und Bekanntmachung des Hinweises auf die Patenterteilung: **14.11.2018**
(21) Anmeldenummer: 17170375.4
(22) Anmeldetag: 10.05.2017
(51) Int. Cl.: G02B 1/04, G02B 6/00

(54) **LINSEN-ELEMENT ZUR BEEINFLUSSUNG EINES VON EINER PHOSPHOR-LED ABGEGEBENEN LICHTS, SOWIE ANORDNUNG ZUR LICHTABGABE MIT EINEM SOLCHEN LINSEN-ELEMENT**
LENS ELEMENT FOR INFLUENCING A LIGHT PRODUCED BY A PHOSPHOROUS LED AND ASSEMBLY FOR EMITTING LIGHT WITH SUCH A LENS ELEMENT
ÉLÉMENT DE LENTILLE DESTINÉ À INFLUENCER UNE LUMIÈRE ÉMISE PAR DES DEL AU PHOSPHORE ET SYSTÈME D'ÉMISSION DE LUMIÈRE COMPRENANT UN TEL ÉLÉMENT DE LENTILLE

(30) Priorität: 11.05.2016 DE 102016208068
(43) Veröffentlichungstag der Anmeldung: 15.11.2017
(73) Patentinhaber: Zumtobel Lighting GmbH, 6850 Dornbirn (AT)
(72) Erfinder: Ludwiczak, Bogna, 88145 Opfenbach (DE); Nenning, Bernhard, 6951 Lingenau (AT)
(74) Vertreter: Thun, Clemens

(56) Entgegenhaltungen:
- DE-A1-102012 108 960
- DE-A1-102012 209 354
- US-A1- 2008 308 825
- US-A1- 2011 001 151
- US-A1- 2011 303 935

## Beschreibung

Die Erfindung betrifft ein Linsen-Element zur Beeinflussung eines von einer Phosphor-LED (LED: Licht emittierende Diode) abgegebenen Lichts, sowie eine Anordnung zur Lichtabgabe mit einem solchen Linsen-Element und einer Phosphor-LED.

Aus dem Stand der Technik ist eine so genannte Phosphor-LED bekannt, die eine LED zur Abstrahlung eines blauen Lichts umfasst sowie eine auf dieser LED aufgebrachte Phosphor-Schicht, durch die das blaue Licht teilweise in ein gelbes Licht umgewandelt wird. Insgesamt erscheint somit das von der Phosphor-LED abgestrahlte Licht weißlich.

Die LED zur Abstrahlung des blauen Lichts weist eine plane Lichtabstrahlfläche auf, sowie eine, normal zu dieser Lichtabstrahlfläche orientierte Hauptabstrahlrichtung. In der Hauptabstrahlrichtung wird von der LED typischerweise am meisten Licht abgegeben. Von der Phosphor-LED wird in eine Abstrahlrichtung, die mit der Hauptabstrahlrichtung einen Winkel von mehr als 60° einschließt - hier im Folgenden auch als "flache Abstrahlrichtung" bezeichnet - typischerweise ein Licht abgestrahlt, das im Vergleich zu dem in der Hauptabstrahlrichtung abgestrahlten Licht rötlicher oder gelblicher erscheint. Das in der Hauptabstrahlrichtung abgestrahlte Licht erscheint demgegenüber weißlicher. Dies wird auch als "Farbwinkelshift" bezeichnet. Dieses Phänomen beruht darauf, dass das von der LED in der flachen Abstrahlrichtung abgestrahlte Licht einen längeren Weg durch die Phosphor-Schicht zurücklegt als das von der LED in die Hauptabstrahlrichtung abgestrahlte Licht.

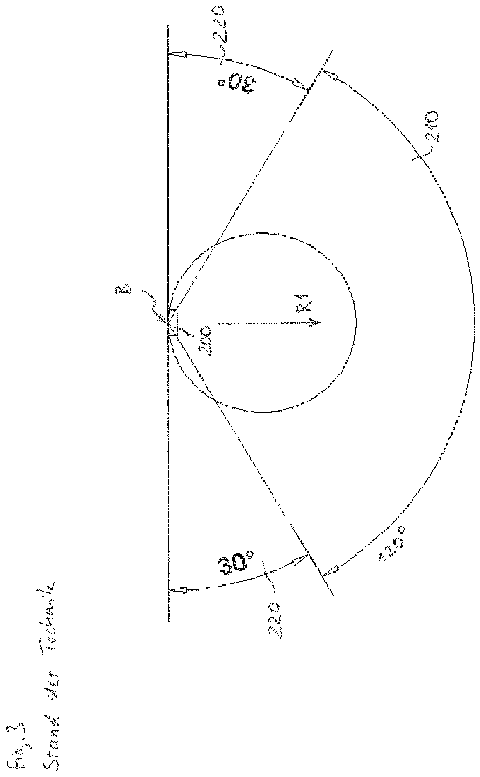

Fig. 3 zeigt eine Skizze zu dem beschriebenen Effekt. Durch eine Phosphor-LED 200 ist eine Hauptabstrahlrichtung R1 festgelegt um die sich ein Zentralbereich 210 breitet, in dem das Licht im Wesentlichen weißlich erscheint. Durch flache Abstrahlrichtungen ist ein, sich an den Zentralbereich 210 anschließender Randbereich 220 gebildet, in dem das Licht mehr rötlich oder gelblich erscheint. Die Verhältnisse sind zumindest in erster Näherung achsensymmetrisch mit Bezug auf die Hauptabstrahlrichtung R1. In dem skizzierten Querschnitt durch die Phosphor-LED 200 umfasst der Zentralbereich 210 - bei einem Bezugspunkt B in der Phosphor-LED 200 - einen Winkelbereich von etwa 120° und die beiden Querschnitt-Teile des Randbereichs 220 jeweils einen Winkelbereich von etwa 30°.

Die beschriebene Eigenschaft der Phosphor-LED wird besonders deutlich, wenn das von der Phosphor-LED abgegebene Licht im Weiteren durch eine Linse oder einen Reflektor beeinflusst wird, so dass die flachen Lichtstrahlen umgelenkt werden; typischerweise ist das bei einer Leuchte der Fall. Es tritt hierbei ein so genannter "Corona-Effekt" auf, bei dem es auf einer bestrahlten Fläche zu einer weißlichen Erscheinung mit einem rötlich-braunen Rand kommt; dabei können auch gelbliche Flecken auftreten.

Um dem - in der Regel unerwünschten - Corona Effekt zu begegnen, ist es bekannt, zur Beeinflussung des Lichts der Phosphor-LED eine Linse mit eingelagerten Streupartikeln zu verwenden. Durch die Streupartikel wird das Licht gestreut, wodurch die unterschiedlichen Farbanteile des Lichts besonders gut durchmischt werden; auf diese Weise wird der Corona-Effekt reduziert. Allerdings wirken die Streupartikel dem eigentlichen Effekt der Linse entgegen, denn durch die Streupartikel werden die Bedingungen für Totalreflexionen in der Linse verschlechtert; dies führt zu einer Verschlechterung des optischen Wirkungsgrads. Außerdem wirkt sich der erhöhte Streulichtanteil nachteilig mit Bezug auf eine mögliche Blendung eines Nutzers aus und damit auf den so genannten UGR-Wert (UGR: unified glare rating).

Außerdem ist es zur Verringerung des Corona-Effekts bekannt, eine spritzgegossene Linse zu verwenden, die eine strukturierte Oberfläche aufweist. Allerdings ist hierdurch lediglich eine sehr begrenzte Verringerung des Corona-Effekts erzielbar, da die Hauptkontur der Linse durch die Strukturierung nicht verändert ist.

Aus der US 2008/0308825 A1 ist ein Linsen-Element zur Beeinflussung eines von einer Phosphor-LED abgegebenen Lichts bekannt. Das Linsen-Element umfasst einen ersten Bereich aus Kunststoff und einen zweiten Bereich, der aus Kunststoff mit darin verteilten Partikeln besteht.

Aus der US 2011/0001151 A1 ist ein Linsen-Element mit eingelagerten Streupartikeln bekannt. Größe und Material der Streupartikel sind so gewählt, dass sie Licht bestimmter Wellenlängen bevorzugt streuen.

Aus der US 2011/0303935 A1 ist ein LED-Modul mit einer Linse bekannt, in der Lumineszenz-Teilchen eingelagert sind.

Weitere optische Elemente zur Beeinflussung eines LED-Lichts zeigen die Schriften DE 10 2012 108 960 A1 und DE 10 2012 209 354 A1.

Der Erfindung liegt die Aufgabe zugrunde, ein entsprechendes verbessertes Linsen-Element anzugeben; insbesondere soll mit dem Linsen-Element vorteilhaft eine

Reduzierung des Corona-Effekts ermöglicht sein. Außerdem soll eine Anordnung zur Lichtabgabe mit einem solchen Linsen-Element angegeben werden.

Diese Aufgabe wird gemäß der Erfindung mit den in den unabhängigen Ansprüchen genannten Gegenständen gelöst. Besondere Ausführungsarten der Erfindung sind in den abhängigen Ansprüchen angegeben.

Gemäß der Erfindung ist ein Linsen-Element zur Beeinflussung eines von einer Phosphor-LED abgegebenen Lichts vorgesehen, das einen ersten Bereich aufweist, der aus einem Kunststoff besteht. Weiterhin weist das Linsen-Element einen zweiten Bereich auf, der aus dem Kunststoff und darin verteilten Pigmentpartikeln besteht.

Durch den zweiten Bereich lässt sich erzielen, dass die unter flachen Abstrahlrichtungen abgestrahlten Lichtanteile der Phosphor-LED in ihrer Farberscheinung verändert werden. So lässt sich der Corona-Effekt reduzieren.

Vorzugsweise ist das Linsen-Element derart gestaltet, dass der zweite Bereich den ersten Bereich umgibt. So eignet sich das Linsen-Element insbesondere zur geeigneten Beeinflussung des von der Phosphor-LED abgestrahlten Lichts in einem besonders großen Winkelbereich, insbesondere wenn das Linsen-Element derart gestaltet ist, dass der zweite Bereich den ersten Bereich auf zwei gegenüberliegenden Seiten oder ringförmig umgibt.

Vorzugsweise ist das Linsen-Element derart gestaltet, dass der zweite Bereich den ersten Bereich symmetrisch umgibt. So lässt sich eine besonders gleichmäßige geeignete Beeinflussung des von der Phosphor-LED abgestrahlten Lichts erzielen; vorzugsweise ist hierzu das Linsen-Element derart gestaltet, dass es in einem Querschnitt betrachtet um eine Symmetrieebene oder eine Symmetrieachse symmetrisch ausgebildet ist, wobei sich vorzugsweise die Symmetrieebene bzw. Symmetrieachse ausschließlich durch den ersten Bereich erstreckt.

Erfindungsgemäß handelt es sich bei den Pigmentpartikeln um Pigmentpartikel, die für blaues Licht durchlässiger sind als für gelbes Licht, insbesondere um so genannte "Blue Color Additive". So lässt sich insbesondere erzielen, dass die von der Phosphor-LED unter flachen Abstrahlrichtungen abgestrahlten Lichtanteile ihren gelblichen bzw. rötlichen Farbanteil verlieren.

Vorzugsweise handelt es sich bei dem Kunststoff um PMMA (Polymethylmethacrylat) oder PC (Polycarbonat). Diese Kunststoffe eignen sich besonders als Linsen-Material.

Herstellungstechnisch vorteilhaft ist das Linsen-Element vorzugsweise als extrudiertes Teil gefertigt. Insbesondere können hierzu der erste Bereich und der zweite Bereich co-extrudiert sein. Alternativ hierzu kann das Linsen-Element herstellungstechnisch vorteilhaft als spritzgegossenes Teil gefertigt sein.

Vorzugsweise weist das Linsen-Element außerdem einen dritten Bereich auf, der aus dem Kunststoff und den darin verteilten Pigmentpartikeln besteht, wobei die Pigmentpartikel in dem dritten Bereich in einer niedrigeren Konzentration verteilt sind als die Pigmentpartikel in dem zweiten Bereich. So lässt sich ein Übergangsbereich erzielen, der optisch zwischen dem ersten und dem zweiten Bereich wirkt.

Gemäß einem weiteren Aspekt der Erfindung ist eine Anordnung zur Lichtabgabe vorgesehen, die eine Phosphor-LED zur Erzeugung eines Lichts aufweist, sowie ein erfindungsgemäßes Linsen-Element zur optischen Beeinflussung des Lichts.

Vorzugsweise ist dabei das Linsen-Element relativ zu der Phosphor-LED derart angeordnet, dass ein erster Anteil des Lichts, der von der Phosphor-LED in eine erste Abstrahlrichtung abgegeben wird, im Weiteren in den ersten Bereich des Linsen-Elements einfällt und ein zweiter Anteil des Lichts, der von der Phosphor-LED in eine zweite Abstrahlrichtung abgegeben wird, im Weiteren in den zweiten Bereich des Linsen-Elements einfällt. So lässt sich der Corona-Effekt besonders wirksam reduzieren.

Vorzugsweise weist die Phosphor-LED eine plane lichtabgebende Fläche auf, wobei die erste Abstrahlrichtung normal zu der planen Fläche orientiert ist und die zweite Abstrahlrichtung mit der ersten Abstrahlrichtung einen Winkel einschließt, der größer als 30° ist, vorzugsweise größer als 45°, besonders bevorzugt größer als 60°.

Die Erfindung wird im Folgenden anhand eines Ausführungsbeispiels und mit Bezug auf die Zeichnungen näher erläutert. Es zeigen:
- Fig. 1: eine Querschnitt-Skizze zu einer anmeldungsgemäßen Anordnung mit einem anmeldungsgemäßen Linsen-Element,
- Fig. 2: ein Diagramm mit zwei beispielhaften Transmissionskurven von Pigmentpartikeln und
- Fig. 3: eine Skizze zur Lichtabstrahlung einer Phosphor-LED gemäß dem Stand der Technik.

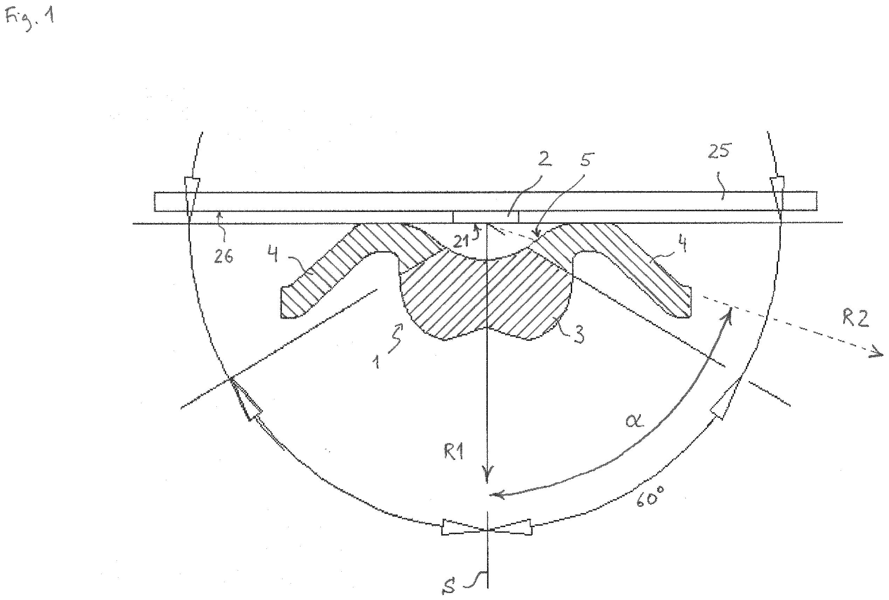

Fig. 1 zeigt eine Querschnitt-Skizze zu einer anmeldungsgemäßen Anordnung zur Lichtabgabe mit einer Phosphor-LED 2 zur Erzeugung eines Lichts und einem anmeldungsgemäßen Linsen-Element 1 zur optischen Beeinflussung des Lichts. Die Phosphor-LED 2 als solche kann so gestaltet sein wie eingangs beschrieben. Sie weist also vorzugsweise eine LED zur Abstrahlung eines blauen Lichts auf, die von einer Phosphorschicht bedeckt ist. Die Richtung, in der die Phosphor-LED 2 am meisten Licht abgibt, wird hier als Hauptabstrahlrichtung R1 bezeichnet. Beispielsweise kann die das blaue Licht abstrahlende LED oder die Phosphor-LED 2 als solche eine plane Lichtabgabefläche 21 aufweisen, wobei die Hauptabstrahlrichtung R1 normal zu dieser Lichtabstrahlfläche 21 orientiert ist.

Die Phosphor-LED 2 kann auf einer Platine 25 angeordnet sein, die insbesondere einen, normal zu der Hauptabstrahlrichtung R1 orientierten planen Oberflächenbereich 26 aufweist.

Typischerweise werden von der Phosphor-LED 2 Lichtstrahlen - zumindest im Wesentlichen - in den gesamten Halbraum abgegeben, der sich symmetrisch um die Hauptabstrahlrichtung R1 aufspannt. In diesem Sinne werden von der Phosphor-LED 2 unter anderem Lichtstrahlen abgegeben, die mit der Hauptabstrahlrichtung R1 einen Winkel von mehr als 60° einschließen. Solche Lichtstrahlen werden hier als "flache" Lichtstrahlen bezeichnet und entsprechende Richtungen als flache Abstrahlrichtungen, wie in Fig. 1 exemplarisch mit einem gestrichelten Pfeil R2 angedeutet.

Zur Beeinflussung des von der Phosphor-LED 2 abgegebenen Lichts weist das Linsen-Element 1 einen ersten Bereich 3 auf, der aus einem Kunststoff besteht. Bei dem Kunststoff kann es sich beispielsweise um PMMA (Polymethylmethacrylat) oder PC (Polycarbonat) handeln.

Weiterhin weist das Linsen-Element 1 einen zweiten Bereich 4 auf, der aus dem Kunststoff und darin verteilten Pigmentpartikeln besteht. Durch die Pigmentpartikel lässt sich erzielen, dass Lichtstrahlen, die von der Phosphor-LED 2 unter flachen Abstrahlrichtungen R2 abgegeben werden, in ihrem Farbverhalten verändert werden. Insbesondere lässt sich auf diese Weise erzielen, dass ein Gelb- oder Rotanteil derartiger Lichtstrahlen durch die Pigmentpartikel reduziert wird.

Dementsprechend ist das Linsen-Element 1 relativ zu der Phosphor-LED 2 vorzugsweise derart angeordnet, dass ein erster Anteil des Lichts, der von der Phosphor-LED 2 in eine erste Abstrahlrichtung abgegeben wird, im Weiteren in den ersten Bereich 3 des Linsen-Elements 1 einfällt und ein zweiter Anteil des Lichts, der von der Phosphor-LED 2 in eine zweite Abstrahlrichtung abgegeben wird, im Weiteren in den zweiten Bereich 4 des Linsen-Elements 1 einfällt. Beispielsweise kann es sich bei der ersten Abstrahlrichtung um die Hauptabstrahlrichtung R1 handeln und bei der zweiten Abstrahlrichtung um eine der flachen Abstrahlrichtungen R2.

Allgemeiner formuliert schließt die zweite Abstrahlrichtung mit der ersten Abstrahlrichtung vorzugsweise einen Winkel α ein, der größer als 30° ist, insbesondere größer als 45°, besonders bevorzugt größer als 60°.

Vorzugsweise sind die Pigmentpartikel hierzu derart gestaltet, dass sie für blaues Licht durchlässiger sind als für gelbes Licht. Vorzugsweise handelt es sich bei den Pigmentpartikeln um organische Pigmentpartikel. Mit anderen Worten sind die Pigmentpartikel vorzugsweise derart gestaltet, dass sie die entsprechenden gelblichen bzw. rötlichen Lichtanteile herausfiltern, bzw. diese Anteile absorbieren, so dass die entsprechenden Lichtstrahlen den gewünschten "Weißton" erhalten. Durch die Pigmentpartikel lässt sich sozusagen eine spektrale Korrektur erzielen.

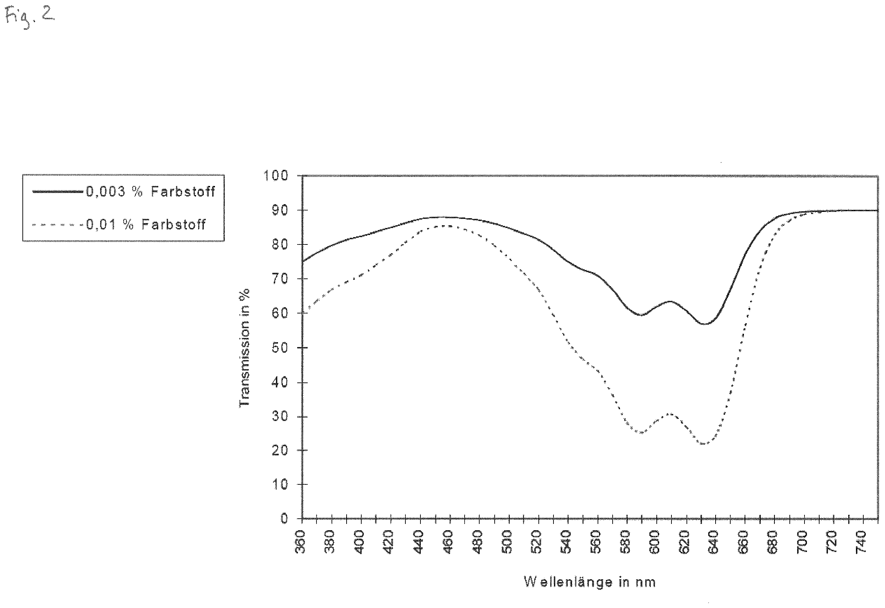

Beispielsweise kann es sich bei den Pigmentpartikeln um so genannte "Blue Color Additive" handeln. In Fig. 2 sind hierzu beispielhaft zwei Transmissionskurven von Kunststoffplatten gezeigt, in denen derartige Pigmentpartikel verteilt sind. Dabei zeigt die gestrichelte Kurve gegenüber der durchgezogenen Kurve einen Fall höherer Konzentration. Wie zu erkennen, wird blaues Licht in beiden Fällen mehr durchgelassen als gelbes, wobei der Effekt mit zunehmender Konzentration steigt.

Beispielsweise kann das Linsen-Element 1 als Profilteil gestaltet sein, so dass der in Fig. 1 gezeigte Querschnitt beispielhaft als entsprechender Querschnitt normal zu der Profilachse des Linsen-Elements 1 aufgefasst werden kann. Wie gezeigt, ist das Linsen-Element 1 vorzugsweise derart gestaltet, dass der zweite Bereich 4 den ersten Bereich 3 umgibt, beispielsweise, wie in diesem Fall, auf zwei gegenüberliegenden Seiten umgibt. So lässt sich geeignet erzielen, dass die von der Phosphor-LED 2 flach abgegebenen Lichtstrahlen auf den zweiten Bereich 4 treffen und in der Folge von diesem optisch beeinflusst werden, während Lichtstrahlen, die in die Hauptabstrahlrichtung R1 abgegeben werden oder in einem kleinen Raumwinkelbereich um die Hauptabstrahlrichtung R1 herum, insbesondere "nicht flache" Lichtstrahlen, auf den ersten Bereich 3 treffen und in der Folge von diesem optisch beeinflusst werden.

Insbesondere kann die Gestaltung derart sein, dass der zweite Bereich 4 den ersten Bereich 3 symmetrisch umgibt. Beispielsweise kann das Linsen-Element 1 spiegelsymmetrisch gestaltet sein, wie im gezeigten Beispiel im Fall des Profilelements, mit Bezug auf eine Symmetrieebene, die durch die Hauptabstrahlrichtung R1 festgelegt ist. Dabei ist die Gestaltung vorzugsweise derart, dass sich die Symmetrieebene ausschließlich durch den ersten Bereich 3 erstreckt.

Wenn das Linsen-Element 1 als Profilteil gestaltet ist, eignet es sich besonders zur Beeinflussung von Licht, das nicht nur von der Phosphor-LED 2 abgegeben wird, sondern von mehreren entsprechenden Phosphor-LEDs abgegeben wird, die längs einer Line parallel zu der Profilachse angeordnet sind, also mit Bezug auf die Fig. 1 normal zur Zeichenebene.

Vorzugsweise ist das Linsen-Element 1 als extrudiertes Teil gefertigt; dieses Herstellungsverfahren eignet sich besonders, wenn das Linsen-Element 1 als Profilteil ausgebildet ist. Dieses Herstellungsverfahren ist zudem besonders geeignet, weil dabei vorteilhaft der erste Bereich 3 und der zweite Bereich 4 co-extrudiert werden können. Dies ist vergleichsweise einfach zu realisieren, da beide Bereiche unter Zuhilfenahme desselben Kunststoffmaterials gefertigt werden können.

Alternativ kann das Linsen-Element 1 auch derart gestaltet sein, dass der zweite Bereich 4 den ersten Bereich 3 ringförmig umgibt, beispielsweise rotationssymmetrisch. Die in Fig. 1 gezeigte Querschnitt-Skizze kann auch in diesem Sinne aufgefasst werden, indem die Hauptabstrahlrichtung R1 als Rotationsachse bzw. Symmetrieachse S des Linsen-Elements 1 angesehen wird.

Vorzugsweise erstreckt sich dabei die Symmetrieachse S ausschließlich durch den ersten Bereich 3. Insbesondere in diesem Fall kann das Linsen-Element 1 alternativ zu dem oben erwähnten Extrusions-Verfahren auch als Spritzgussteil gefertigt sein. In diesem Fall kommt vorzugsweise eine Mehrkomponenten-Technologie zum Bilden der beiden Bereiche 3, 4 zum Einsatz.

Gemäß einer Variation, die sich insbesondere bei einer Herstellung im Spritzgussverfahren anbietet, kann vorgesehen sein, dass das Linsen-Element 1 außerdem einen dritten Bereich aufweist, der aus dem Kunststoff und den darin verteilten organischen Pigmentpartikeln besteht, wobei die Pigmentpartikel in dem dritten Bereich in einer niedrigeren Konzentration verteilt sind als die Pigmentpartikel in dem zweiten Bereich 4. Insbesondere kann der dritte Bereich zwischen dem ersten Bereich 3 und dem zweiten Bereich 4 angeordnet sein. Durch den dritten Bereich lässt sich quasi ein Übergangsbereich zwischen dem ersten Bereich 3 und dem zweiten Bereich 4 bilden, so dass Farbbeeinflussungen noch feiner abgestimmt realisierbar sind.

Natürlich sind in Erweiterung hierzu entsprechende noch feinere Abstufungen möglich, wobei die Bereiche vorzugsweise derart angeordnet sind, dass ihre Konzentrationen mit zunehmender Winkelbereichs-Entfernung von der Hauptabstrahlrichtung R1, also quasi "nach außen" bzw. zu den Seiten hin zunehmen.

Das Linsen-Element 1 kann jedenfalls, also insbesondere sowohl bei Herstellung im Spritzgussverfahren, als auch bei Herstellung im Extrusions-Verfahren als aus einem Stück bestehend gebildet sein, also sozusagen "einstückig".
Vorteilhaft weist das Linsen-Element 1 jedenfalls einen konkaven Oberflächenbereich 5 auf, der als Lichteintrittsfläche für das von der Phosphor-LED 2 abgegebene Licht dient.

Eine Grenzfläche zwischen dem ersten Bereich 3 und dem zweiten Bereich 4 ist vorzugsweise derart gestaltet, dass sie eine Ebene oder auf eine Kegelfläche beschreibt, wobei die Ebene bzw. die Kegelfläche durch die Phosphor-LED 2 verläuft bzw. durch einen, für die Phosphor-LED 2 vorgesehenen Ortsbereich.

Ein Vorteil des anmeldungsgemäßen Linsen-Elements 1 besteht auch darin, dass die aufgrund des optischen Linsen-Elements 1 entstehenden optischen Verluste vergleichsweise klein gehalten werden können, da es bei typischen Bedingungen ausreichend ist, wenn lediglich ca. 6% des von der Phosphor-LED 2 abgegebenen Lichts mit den Pigmentpartikeln absorbiert wird.

## Patentansprüche

1. Linsen-Element (1) zur Beeinflussung eines von einer Phosphor-LED (2) abgegebenen Lichts, aufweisend
- einen ersten Bereich (3), der aus einem Kunststoff besteht,
**gekennzeichnet durch**
- einen zweiten Bereich (4), der aus dem Kunststoff und darin verteilten Pigmentpartikeln besteht,
wobei es sich bei den Pigmentpartikeln um Pigmentpartikel handelt, die für blaues Licht durchlässiger sind als für gelbes Licht.

2. Linsen-Element (1) nach Anspruch 1,
**dadurch gekennzeichnet,**
**dass** das Linsen-Element (1) derart gestaltet ist, dass der zweite Bereich (4) den ersten Bereich (3) umgibt.

3. Linsen-Element (1) nach Anspruch 1 oder 2,
**dadurch gekennzeichnet,**
**dass** das Linsen-Element (1) derart gestaltet ist, dass der zweite Bereich (4) den ersten Bereich (3) auf zwei gegenüberliegenden Seiten oder ringförmig umgibt.

4. Linsen-Element (1) nach einem der vorhergehenden Ansprüche,
**dadurch gekennzeichnet,**
**dass** das Linsen-Element (1) derart gestaltet ist, dass der zweite Bereich (4) den ersten Bereich (3) symmetrisch umgibt.

5. Linsen-Element (1) nach einem der vorhergehenden Ansprüche,
**dadurch gekennzeichnet,**
**dass** das Linsen-Element (1) derart gestaltet ist, dass es in einem Querschnitt betrachtet um eine Symmetrieebene oder Symmetrieachse (S) symmetrisch ausgebildet ist, wobei sich vorzugsweise die Symmetrieebene bzw. Symmetrieachse (S) ausschließlich durch den ersten Bereich (3) erstreckt.

6. Linsen-Element (1) nach einem der vorhergehenden Ansprüche,
**dadurch gekennzeichnet,**
**dass** es sich bei den Pigmentpartikeln um so genannte "Blue Color Additive" handelt.

7. Linsen-Element (1) nach einem der vorhergehenden Ansprüche,
**dadurch gekennzeichnet,**
**dass** es sich bei dem Kunststoff um PMMA oder PC handelt.

8. Linsen-Element (1) nach einem der vorhergehenden Ansprüche,
**dadurch gekennzeichnet,**
**dass** das Linsen-Element (1) als extrudiertes Teil gefertigt ist, wobei insbesondere der erste Bereich (1) und der zweite Bereich (4) co-extrudiert sind.

9. Linsen-Element (1) nach einem der Ansprüche 1 bis 7,
**dadurch gekennzeichnet,**
**dass** das Linsen-Element (1) als spritzgegossenes Teil gefertigt ist.

10. Linsen-Element (1) nach einem der vorhergehenden Ansprüche,
**gekennzeichnet durch**
- einen dritten Bereich, der aus dem Kunststoff und den darin verteilten Pigmentpartikeln besteht, wobei die Pigmentpartikel in dem dritten Bereich in einer niedrigeren Konzentration verteilt sind als die Pigmentpartikel in dem zweiten Bereich (4).

11. Anordnung zur Lichtabgabe,
aufweisend
- eine Phosphor-LED (2) zur Erzeugung eines Lichts,
**gekennzeichnet durch**
- ein Linsen-Element (1) nach einem der Ansprüche 1 bis 10 zur optischen Beeinflussung des Lichts.

12. Anordnung zur Lichtabgabe nach Anspruch 11,
**dadurch gekennzeichnet,**
**dass** das Linsen-Element (1) relativ zu der Phosphor-LED (2) derart angeordnet ist, dass ein erster Anteil des Lichts, der von der Phosphor-LED (2) in eine erste Abstrahlrichtung abgegeben wird, im Weiteren in den ersten Bereich (3) des Linsen-Elements (1) einfällt und ein zweiter Anteil des Lichts, der von der Phosphor-LED (2) in eine zweite Abstrahlrichtung abgegeben wird, im Weiteren in den zweiten Bereich (4) des Linsen-Elements (1) einfällt.

13. Anordnung zur Lichtabgabe nach Anspruch 12,
**dadurch gekennzeichnet,**
**dass** die Phosphor-LED (2) eine plane lichtabgebende Fläche (21) aufweist, wobei die erste Abstrahlrichtung normal zu der planen Fläche (21) orientiert ist und die zweite Abstrahlrichtung mit der ersten Abstrahlrichtung einen Winkel (α) einschließt, der größer als 30° ist, vorzugsweise größer als 45°, besonders bevorzugt größer als 60°.

## Claims

1. Lens element (1) for influencing a light emitted from a phosphor LED (2), comprising
- a first region (3), which consists of a plastic, **characterized by**
- a second region (4) consisting of the plastic and pigment particles dispersed therein,
wherein the pigment particles are pigment particles which are more permeable to blue light than to yellow light.

2. Lens element (1) according to claim 1, **characterized in that** the lens element (1) is so designed that the second region (4) surrounds the first region (3).

3. Lens element (1) according to claim 1 or 2, **characterized in that** the lens element (1) is so designed that the second region (4) surrounds the first region (3) on two opposite sides or in an annular manner.

4. Lens element (1) according to any one of the preceding claims, **characterized in that** the lens element (1) is so designed that the second region (4) surrounds the first region (3) in a symmetrical manner.

5. Lens element (1) according to any one of the preceding claims, **characterized in that** the lens element (1) is so designed that when it is viewed in a cross-section, it is symmetrical about a symmetry plane or symmetry axis (S), wherein the symmetry plane or symmetry axis (S) preferably extends exclusively through the first region (3).

6. Lens element (1) according to one of the preceding claims, **characterized in that** the pigment particles are so-called "blue color additives".

7. Lens element (1) according to one of the preceding claims, **characterized in that** the plastic is PMMA or PC.

8. Lens element (1) according to any one of the preceding claims, **characterized in that** the lens element (1) is made as an extruded part, wherein, in particular, the first region (1) and the second region (4) are co-extruded.

9. Lens element (1) according to one of the claims 1 to 7, **characterized in that** the lens element (1) is made as an injection-molded part.

10. Lens element (1) according to one of the preceding claims, **characterized in that**
- a third region consists of the plastic and the pigment particles dispersed therein, wherein the pigment particles in the third region are distributed in a lower concentration than the pigment particles in the second region (4).

11. Arrangement for emitting light, comprising
- a phosphor LED (2) for producing a light, **characterized by**
- a lens element (1) according to any one of claims 1 to 10 for the optical influence of the light.

12. Arrangement for emitting light according to claim 11, **characterized in that** the lens element (1) is so arranged relative to the phosphor LED (2) that a first portion of the light from the phosphor LED (2) that is emitted in a first emission direction, then strikes the first region (3) of lens element (1), while a second portion of the light is emitted from the phosphor LED (2) in a second emission direction, and then strikes the second region (4) of the lens element (1).

13. Arrangement for emitting light according to claim 12, **characterized in that** the phosphor LED (2) has a planar light-emitting surface (21), wherein the first emission direction is oriented normal to the planar surface (21), while the second emission direction is at an angle (α) to the first radiation direction, which is greater than 30°, preferably greater than 45°, more preferably greater than 60°.

## Revendications

1. Élément de lentille (1) pour le contrôle d'une lumière émise par une LED au phosphore (2), comprenant :
- une première zone (3), qui est constituée d'une matière plastique, **caractérisé par**
- une deuxième zone (4), qui est constituée de la matière plastique et de particules de pigments réparties dans celle-ci,
les particules de pigments étant des particules de pigments qui sont plus transparents pour la lumière bleue que pour la lumière jaune.

2. Élément de lentille (1) selon la revendication 1,
**caractérisé en ce que**
l'élément de lentille (1) est conçu de façon à ce que la deuxième zone (4) entoure la première zone (3).

3. Élément de lentille (1) selon la revendication 1 ou 2,
**caractérisé en ce que**
l'élément de lentille (1) est conçu de façon à ce que la deuxième zone (4) entoure la première zone (3) sur deux côtés opposés ou de manière annulaire.

4. Élément de lentille (1) selon l'une des revendications précédentes,
**caractérisé en ce que**
l'élément de lentille (1) est conçu de façon à ce que la deuxième zone (4) entoure la première zone (3) de manière symétrique.

5. Élément de lentille (1) selon l'une des revendications précédentes,
**caractérisé en ce que**
l'élément de lentille (1) est conçu de façon à ce que, vu en coupe transversale, il soit conçu de manière symétrique autour d'un plan de symétrie ou d'un axe de symétrie (S), le plan de symétrie ou l'axe de symétrie (S) s'étendant de préférence exclusivement à travers la première zone (3).

6. Élément de lentille (1) selon l'une des revendications précédentes,
**caractérisé en ce que**
les particules de pigments sont ce qu'on appelle des « Blue Color Additive ».

7. Élément de lentille (1) selon l'une des revendications précédentes,
**caractérisé en ce que**
la matière plastique est du PMMA ou du PC.

8. Élément de lentille (1) selon l'une des revendications précédentes,
**caractérisé en ce que**
l'élément de lentille (1) est fabriqué comme une pièce extrudée, plus particulièrement la première zone (1) et la deuxième zone (4) étant co-extrudées.

9. Élément de lentille (1) selon l'une des revendications 1 à 7,
**caractérisé en ce que**
l'élément de lentille (1) est fabriqué comme une pièce moulée par injection.

10. Élément de lentille (1) selon l'une quelconque des revendications précédentes,
**caractérisé par**
- une troisième zone qui est constituée de la matière plastique et des particules de pigments réparties dans celui-ci, les particules de pigments étant réparties dans la troisième zone dans une concentration plus faible que les particules de pigments dans la deuxième zone (4).

11. Dispositif d'émission de lumière,
comprenant
- une LED au phosphore (2) pour la production d'une lumière,
**caractérisé par**
- un élément de lentille (1) selon l'une des revendications 1 à 10 pour le contrôle optique de la lumière.

12. Dispositif d'émission de lumière selon la revendication 11,
**caractérisé en ce que**
l'élément de lentille (1) est disposé par rapport à la LED au phosphore (2) de façon à ce qu'une première partie de la lumière, qui est émise par la LED au phosphore (2) dans une première direction d'émission, arrive en outre dans la première zone (3) de l'élément de lentille (1) et une deuxième partie de la lumière, qui est émise par la LED au phosphore (2) dans une deuxième direction d'émission, arrive en outre dans la deuxième zone (4) de l'élément de lentille (1).

13. Dispositif d'émission de lumière selon la revendication 12,
**caractérisé en ce que**
la LED au phosphore (2) comprend une surface plane émettrice de lumière (21), la première direction d'émission étant orientée de manière normale par rapport à la surface plane (21) et la deuxième direction d'émission forme, avec la première direction d'émission, un angle (α) qui est supérieur à 30°, de préférence supérieur à 45°, plus particulièrement de préférence supérieur à 60°.
